# EUROPÄISCHE PATENTANMELDUNG

(11) **EP 3 352 533 A1**
(43) Veröffentlichungstag der Anmeldung: **25.07.2018**
(21) Anmeldenummer: 17203554.5
(22) Anmeldetag: 24.11.2017
(51) Int. Cl.: H05B 37/02, G05G 1/08, G05G 13/00, H01H 19/60

(54) **LICHTSTELLPULT MIT DOPPELWELLENENCODER**

(30) Priorität: 18.01.2017 DE 202017100249 U
(71) Anmelder: MA Lighting Technology GmbH, 97297 Waldbüttelbrunn (DE)
(72) Erfinder: ADENAU, Michael, 97082 Würzburg (DE)
(74) Vertreter: advotec.

(57) **Zusammenfassung**

Die Erfindung betrifft ein Lichtstellpult (01) zur Steuerung einer Beleuchtungsanlage, wobei im Lichtstellpult (01) digitale Stellbefehle erzeugt werden, die über Datenverbindungen an die Beleuchtungseinrichtungen der Beleuchtungsanlage übertragen werden können, und wobei das Lichtstellpult (01) zumindest einen Digitalprozessor und zumindest einen Digitalspeicher zur Erzeugung, Verwaltung und Speicherung der Stellbefehle umfasst, und wobei das Lichtstellpult (01) zumindest eine Anzeigeeinrichtung umfasst, und wobei an der Anzeigeeinrichtung Grafikelemente für den Benutzer grafisch dargestellt werden können, wobei im Bedienfeld (08) des Lichtstellpults (01) zumindest ein Doppelwellenencoder (07) vorgesehen ist, an dem Eingabewerte vom Benutzer eingegeben werden können, wobei der Doppelwellenencoder (07) eine erste drehbar in einem Gehäuse (16) gelagerte Welle (09) aufweist, und wobei an der ersten Welle (09) ein erstes Rastwerk zur Verrastung unterschiedlicher Drehlagen der ersten Welle (09) und zumindest ein erster Drehsignalgeber (26, 27) zur Erzeugung eines ein Umschalten zwischen zwei Rastlagen anzeigenden Datensignals vorgesehen sind, und wobei am Doppelwellenencoder (07) eine zweite, koaxial drehbar in dem Gehäuse (16) gelagerte Welle (10) vorgesehen ist, und wobei an der zweiten Welle (10) ein zweites Rastwerk zur Verrastung unterschiedlicher Drehlagen der zweiten Welle (10) und zumindest ein zweiter Drehsignalgeber (28, 29) zur Erzeugung eines ein Umschalten zwischen zwei Rastlagen anzeigenden Datensignals vorgesehen sind, und wobei beide Wellen (09, 10) Betätigungselemente (11, 12) aufweisen, an denen Stellbewegungen von Hand auf die Wellen (09, 10) übertragen werden können.

## Beschreibung

Die Erfindung betrifft ein Lichtstellpult mit Doppelwellenencoder nach dem Oberbegriff des Anspruchs 1.

Gattungsgemäße Lichtstellpulte dienen zur Steuerung von Beleuchtungsanlagen, wie sie beispielsweise in Theatern oder Konzertbühnen zum Einsatz kommen. Diese Beleuchtungsanlagen umfassen regelmäßig eine Vielzahl von Beleuchtungseinrichtungen, beispielweise Bühnenscheinwerfer, wobei die Beleuchtungseinrichtungen vielfach auch noch für sich genommen zwischen einer Vielzahl von Beleuchtungszuständen, beispielsweise unterschiedlichen Farben, umgeschaltet werden können. Diese unterschiedlichen Beleuchtungszustände werden durch programmierte Parameter im Beleuchtungsprogramm des Lichtstellpults gespeichert und gesteuert. Übliche Beleuchtungsanlagen können dabei bis zu mehrere Tausend Beleuchtungseinrichtungen umfassen. Um derart komplexe Beleuchtungsanlagen steuern zu können, sind die gattungsgemäßen Lichtstellpulte mit einem Digitalprozessor ausgestattet, der eine digitale Daten- und Signalverarbeitung erlaubt. Zur Speicherung der Daten ist weiter ein Digitalspeicher vorgesehen, der es insbesondere ermöglicht, Beleuchtungsprogramme zu archivieren.

Zur Programmierung des Beleuchtungsprogramms bzw. zur Steuerung des Beleuchtungsprogramms während seines Ablaufs müssen vom Bediener Bedienbefehle als Eingabewerte eingegeben werden. Dabei kann es sich beispielsweise um die Auswahl einer bestimmten Beleuchtungseinrichtung bzw. um die Einstellung eines bestimmten Parameters handeln. Für die Eingabe dieser Bedienbefehle sind an bekannten Lichtstellpulten mechanische Bedienelemente, beispielsweise Taster, Drehregler oder Schieberegler, vorhanden. Die den einzelnen Bedienelementen zugeordneten Bedienbefehle können dabei durch geeignete Menüumschaltung verändert werden, um entsprechend komplexe Beleuchtungsprogramme programmieren und steuern zu können.

Bei Doppelwellenencodern handelt es sich um Eingabevorrichtungen, an denen ein Benutzer durch Verdrehen eines Betätigungselements ein zugeordnetes elektrisches Signal eingeben kann. Doppelwellenencoder sind dabei dadurch charakterisiert, dass diese nicht nur ein Betätigungselement, beispielsweise einen Drehknopf oder eine Drehscheibe, aufweisen, sondern zwei. Beide Betätigungselemente sind dabei mit einer drehbar gelagerten Welle verbunden. Beiden Wellen ist jeweils ein Drehsignalgeber zugeordnet, der das Verdrehen der Welle unmittelbar oder mittelbar detektieren kann. Die beiden Drehsignalgeber erzeugen dann jeweils nach Detektion einer Stellbewegung an der Welle ein elektrisches Signal.

Außerdem sind die beiden Wellen jeweils mit einem Rastwerk ausgestattet, das die Wellen in unterschiedlichen Drehlagen verrasten kann. Die vom Drehsignalgeber erzeugten Signale können auf diese Weise das Umschalten zwischen zwei Rastlagen durch Verdrehen der Welle anzeigen.

Bekannte Doppelwellenencoder können beispielsweise, jedoch keineswegs ausschließlich, dazu genutzt werden, zwei Stellwerte, beispielsweise den X-Wert und den Y-Wert in einem kartesischen Koordinatensystem, mit jeweils diskreten Wertangaben mit kleinsten Stellbewegungen der Hand an einem Gerät einzugeben. Aus der DE 33 36 746 A1 ist ein einfacher Encoder, der in der Art eines Drehschalters ausgebildet ist, bekannt. Dieser Encoder besitzt ein mechanisches Rastwerk, das die Welle in unterschiedlichen Rastlagen fixieren kann. Nachteilig an diesem mechanischen Rastwerk ist es, dass die mechanischen Verbindungen des Rastwerks einem relativ hohen Verschleiß unterworfen sind, durch den das Rastwerk nach einer bestimmten Betriebszeit schwergängig wird oder gänzlich versagt.

Ausgehend von diesem Stand der Technik ist es deshalb Aufgabe der vorliegenden Erfindung, ein neues Lichtstellpult mit Doppelwellenencoder vorzuschlagen, dessen Rastwerke zur Fixierung der drehbaren Wellen in unterschiedlichen Drehlagen weitgehend verschleißfrei arbeiten.

Vorteilhafte Ausführungsformen der Erfindung sind Gegenstand der Unteransprüche.

Das erfindungsgemäße Lichtstellpult ist im Bedienfeld mit zumindest einem Doppelwellenencoder zur Eingabe von Eingabewerten ausgestattet. Die Erfindung beruht auf dem Grundgedanken, dass beide Wellen des Doppelwellenencoders, an denen der Benutzer seine Stellbewegungen per Hand am Doppelwellenencoder eingibt, mit einem magnetischen Rastwerk ausgestattet sind, so dass aufgrund der berührungslosen Funktionsweise der magnetischen Rastwerke kein wesentlicher Verschleiß an den Rastwerken auftritt. Konkret wird dies konstruktiv dadurch erreicht, dass an beiden Wellen ein Rastring aus einem magnetisierbaren Material drehfest angeordnet ist. Am Außenumfang der beiden Rastringe sind dabei jeweils Radialfortsätze vorgesehen, so dass der Außenumfang zwischen einem Maximalwert am äußeren Ende der Radialfortsätze und einem Minimalwert, nämlich an den Nuten zwischen den Radialfortsätzen, abwechselt. Dieser sich ändernde Außenumfang des Rastrings wird nun zur Bildung eines hermetischen Rastwerks dadurch genutzt, dass ein Magnet im Gehäuse den Radialfortsätzen gegenüberliegend angeordnet ist. Liegt nun ein Radialfortsatz dem Magneten direkt gegenüber, so ist die Breite des Luftspalts zwischen dem entsprechenden Rastring und dem Magneten minimal, so dass die vom magnetischen Fluss des Magneten auf den Rastring ausgeübte Haltekraft ein Maximum einnimmt. Liegt dagegen eine Nut des Rastrings dem Magneten gegenüber, schwächt sich der magnetische Fluss des Magneten durch den Rastring ab, und die auf den Rastring ausgeübte Haltekraft sinkt auf ein Minimum. Dies bedeutet mit anderen Worten, dass durch die Variation der Breite des Luftspalts zwischen dem Magneten einerseits und den Rastringen andererseits, die durch die Variation des Außenumfangs des Rastrings mit seinen Radialfortsätzen verursacht wird, der vom Magneten auf den Rastring ausgeübte magnetische Fluss aufgrund der Änderung der Breite des Luftspalts variiert werden kann. Durch diese Änderung des magnetischen Flusses und der dadurch ausgeübten magnetischen Haltekraft bewirkt der Magnet eine drehlagenabhängige Verrastung der jeweils zugeordneten Welle im Gehäuse.

Um eine besonders kompakte Bauweise des Doppelwellenencoders zu ermöglichen, ist es besonders vorteilhaft, wenn die beiden Wellen koaxial zueinander verlaufen. Um dies zu ermöglichen, wird eine der beiden Wellen in der Art einer Hohlwelle ausgebildet, die mit zumindest einem Wälzlager im Gehäuse des Doppelwellenencoders drehbar gelagert ist. In dieser Hohlwelle wird dann wiederum die zweite Welle mit zumindest einem weiteren Wälzlager drehbar gelagert. Auf diese Weise können beide Wellen unabhängig voneinander vom Benutzer verdreht werden, um entsprechende Einstellungen mittels des Doppelwellenencoders vorzunehmen.

Ein besonders einfacher und kostengünstiger Aufbau des Doppelwellenencoders ergibt sich, wenn die beiden Rastringe mit ihren Radialfortsätzen den gleichen Außenumfang aufweisen und in Richtung der Längsachse der Wellen hintereinander im Gehäuse angeordnet sind. Der Magnet zur Realisation der beiden Rastwerke wird im Gehäuse des Doppelwellenencoders so angeordnet, dass er dem Spalt zwischen den beiden Rastringen mittig gegenüberliegt. Auf diese Weise kann ein Magnet gleichzeitig an beiden Rastringen einen magnetischen Fluss aufbauen. Zur Realisation der beiden Rastwerke an den beiden Rastringen ist deshalb bereits ein einziger Magnet, der zugleich auf beide Rastringe wirkt, ausreichend.

Die magnetische Haltekraft des im Rastwerk verwendeten Magneten zieht die Rastringe an, so dass auf die beiden Wellen jeweils ein Kippmoment wirkt. Um dieses Kippmoment auszugleichen und dadurch einem Verschleiß der Lagerung der Wellen vorzubeugen, ist es besonders vorteilhaft, wenn zur Realisation der Rastwerke jeweils zwei Magnete spiegelsymmetrisch zur Längsachse der Wellen im Gehäuse angeordnet sind. Auf diese Weise wirkt das Kippmoment der beiden Magnete mit umgekehrten Vorzeichen auf die Wellen und löscht sich dadurch im Ergebnis aus. Abhängig von der Funktion des Doppelwellenencoders kann es wünschenswert sein, dass die Verrastung der beiden Rastwerke einen unterschiedlichen Rastwiderstand aufweist. Solche Rastwerke mit unterschiedlichem Rastwiderstand können in dem Doppelwellenencoder in einfacher Weise dadurch realisiert werden, dass beiden Rastringen jeweils zumindest ein Magnet exklusiv zugeordnet ist, wobei die verschiedenen Magnete jeweils mit unterschiedlicher magnetischer Haltekraft auf die Rastringe der beiden Wellen einwirken. Beispielsweise kann dem einen Rastring ein kleiner, relativ schwacher Magnet zugeordnet sein, um eine schwache Verrastung zu realisieren, wohingegen der zweite Rastring mit einem stärkeren und größeren Magneten zusammenwirkt, um eine stärkere Verrastung zu realisieren.

Welche Art von Drehsignalgeber zur Detektion der Stellbewegungen an den beiden Wellen eingesetzt wird, ist grundsätzlich beliebig. Im Hinblick auf eine möglichst hohe Verschleißfestigkeit ist es besonders vorteilhaft, wenn ein berührungslos arbeitender Drehsignalgeber, insbesondere eine Reflexlichtschranke oder ein Hallsensor, eingesetzt wird. Dabei wird die Konstruktion des Doppelwellenencoders erheblich vereinfacht, wenn dieser berührungslos arbeitende Drehsignalgeber die Stellbewegungen der Radialfortsätze an den Rastringen zur Erzeugung des Umschaltsignals zwischen zwei Rastlagen detektiert. Dies bedeutet dann mit anderen Worten, dass die Radialfortsätze an den Rastringen nicht nur zur Bildung des magnetischen Rastwerks dienen, sondern zugleich auch zur Detektion der Stellbewegungen an den Wellen des Doppelwellenencoders genutzt werden.

Bei verschiedenen Anwendungen von Doppelwellenencodern ist es neben der Generierung eines Umschaltsignals bei der Verstellung zwischen zwei Rastlagen weiterhin von Bedeutung, auch die Drehrichtung der entsprechenden Welle zu detektieren. Um den Einbau eines spezifischen Drehrichtungssensors zu vermeiden, können jedem der Rastringe zwei Drehsignalgeber zugeordnet werden. Bei der Auswertung der Umschaltsignale der einem Rastring zugeordneten zwei Drehsignalgeber treten dann Phasenverschiebungen zwischen den Umschaltsignalen auf, die die Drehrichtung des zugeordneten Rastrings angeben. Ist der eine Drehsignalgeber beispielsweise etwas im Uhrzeigersinn versetzt gegenüber dem zweiten Drehsignalgeber im Gehäuse angeordnet, kann aus der Phasenverschiebung der beiden Drehsignalgeber problemlos detektiert werden, in welcher Richtung sich der Rastring dreht.

Für bestimmte Funktionen ist es vorteilhaft, dass nach der Einstellung einer der beiden Wellen des Doppelwellenencoders, beispielsweise zur Auswahl eines X- oder Y-Werts, der entsprechende Wert ausgewählt und vom Benutzer bestätigt werden kann. Diese Auswahl und Bestätigung eines an den Wellen eingestellten Werts kann in einfacher Weise dadurch realisiert werden, dass zumindest eine der beiden Wellen zwischen einer Ruhestellung und einer Schaltstellung in Richtung ihrer Längsachse axial verstellbar gelagert ist. Dies bedeutet also, dass die Welle nicht nur drehbar, sondern auch axial verstellbar gelagert ist. Um die Auswahl und Bestätigung eines eingestellten Werts dann zu realisieren, wird im Gehäuse zusätzlich ein Schaltsensor vorgesehen, mit dem die Verstellung der axial verstellbaren Welle zwischen der Ruhestellung und der Schaltstellung detektiert werden kann. Hat nun der Benutzer durch Verdrehen der Welle einen bestimmten Wert eingestellt, was durch Auswertung der Signale des Drehsignalgebers elektronisch auswertbar ist, kann der Benutzer dann die axial verstellbare Welle kurz drücken und dadurch von ihrer Ruhestellung in die Schaltstellung bringen. Diese Verstellung kann dann mit dem Schaltsensor detektiert werden, so dass der an der Welle eingestellte Wert damit vom Benutzer ausgewählt und bestätigt ist und einer weiteren elektronischen Verarbeitung zugeführt werden kann.

Im Hinblick auf die Verschleißfestigkeit des Doppelwellenencoders ist es wiederum besonders vorteilhaft, wenn auch der Schaltsensor als berührungslos arbeitender Schaltsensor, insbesondere als Reflexlichtschranke oder als Hallsensor, ausgebildet ist.

Im Hinblick auf eine einfache und zuverlässige Signalauswertung des Schaltsensors kann an der axial verstellbaren Welle zusätzlich eine Signalscheibe befestigt werden. Diese Signalscheibe kann dem berührungslos arbeitenden Schaltsensor, beispielsweise einer Reflexlichtschranke, gegenüberliegend angeordnet werden. Durch Verstellung der axial verstellbaren Welle zwischen ihrer Ruhestellung und der Schaltstellung gelangt dann die Signalscheibe in eine Lage, in der der Abstand zwischen Schaltsensor und Signalscheibe signifikant kleiner oder größer wird, um somit durch den berührungslos arbeitenden Schaltsensor, beispielsweise eine Reflexlichtschranke oder einen Hallsensor, problemlos ausgewertet werden zu können.

Um die Funktion des Doppelwellenencoders bei axial verstellbarer Lagerung zumindest einer Welle zu realisieren, ist es notwendig, dass die axial verstellbare Welle im Normalfall ohne Zutun des Benutzers in ihrer Ruhestellung gehalten wird. Im Hinblick auf einen möglichst verschleißfreien Betrieb des Doppelwellenencoders kann diese Rückstellung der axial verstellbaren Welle in ihre Ruhestellung durch einen Rückstellmagneten realisiert werden. Auch dieser Rückstellmagnet wirkt mit seiner Rückstellkraft berührungslos auf die zugeordneten Bauteile der axial verstellbaren Welle.

Im Hinblick auf den Bedienungskomfort und einen möglichst geringen Verschleiß ist es außerdem vorteilhaft, wenn die Stellbewegung der axial verstellbaren Welle zwischen der Ruhestellung und der Schaltstellung bzw. umgekehrt gedämpft wird. Dazu kann ein Dämpfungselement, beispielsweise ein Gummiring, verwendet werden, der an einem Bauteil der verstellbar gelagerten Welle dämpfend zur Anlage kommen kann.

Im Hinblick auf eine einfache Bedienung bei der Eingabe von Werten an dem erfindungsgemäßen Lichtstellpult mit dem Doppelwellenencoder bei der Programmierung des Lichtstellpults ist es besonders vorteilhaft, wenn die Betätigungselemente zur handbetätigten Verstellung der Wellen in der Art von Drehknöpfen oder Drehscheiben ausgebildet sind, die im Bedienfeld des Lichtstellpults angeordnet werden. Die beiden Drehknöpfe bzw. Drehscheiben des Doppelwellenencoders werden dabei in Richtung der Längsachse der Wellen übereinander angeordnet und können koaxial gegeneinander verdreht werden, so dass der Benutzer allein durch Bewegungen der Finger beide Betätigungselemente problemlos einstellen kann.

Das magnetisch wirkende Rastwerk an den beiden Wellen des Doppelwellenencoders arbeitet berührungslos, so dass bei der Verstellung der Wellen im Wesentlichen keinerlei Reibungsverluste auftreten. Um eine Verstellung der Wellen durch einen Drehimpuls des Benutzers an dem jeweils zugeordneten Betätigungselement zu ermöglichen, ist es besonders vorteilhaft, wenn das entsprechende Betätigungselement mit einem Beschwerungsgewicht ausgestattet ist. Durch das Beschwerungsgewicht ist es möglich, einen höheren Drehimpuls auf das Betätigungselement zu übertragen, so dass die entsprechende Welle des Doppelwellenencoders entsprechend lange nachläuft und eine bequeme Verstellung über weite Stellwege ermöglicht.

Welche Art von Magnet für das Rastwerk des Doppelwellenencoders verwendet wird, ist grundsätzlich beliebig. Besonders einfach, zuverlässig und preisgünstig kann der Aufbau des Rastwerks bei Verwendung von Permanentmagneten realisiert werden.

Alternativ zu Permanentmagneten können im Rastwerk auch Elektromagnete eingesetzt werden. Durch Veränderung oder Abschaltung der Energieversorgung des Elektromagnets kann die im Rastwerk wirkende magnetische Haltekraft funktionsabhängig verändert werden.

Die erfindungsgemäße Vorrichtung dient insbesondere dem Einsatz eines Verfahrens zur Eingabe von Eingabewerten am erfindungsgemäßen Lichtstellpult mit Doppelwellenencoder. Das Verfahren ist dadurch gekennzeichnet, dass zwei Eingabewerte ohne Versetzen der Hand auf dem Bedienfeld sehr schnell eingegeben werden können. Dazu ist gemäß dem Verfahren vorgesehen, dass zunächst die erste Welle verdreht wird, und durch Auswertung der dadurch erzeugten Datensignale des ersten Drehsignalgebers der erste Eingabewert festgestellt wird. Anschießend kann der Benutzer dann die zweite Welle des Doppelwellenencoders verdrehen, wobei durch Auswertung der dadurch erzeugten Datensignale des zweiten Drehsignalgebers der zweite Eingabewert festgestellt wird. Diese Art der Eingabe ist insbesondere dann von Vorteil, wenn die beiden Eingabewerte ein Eingabewertepaar bilden, das zusammen einer weiteren Verarbeitung zugeführt werden soll. Da der Benutzer bei der Eingabe der beiden Eingabewerte die Hand im Bedienfeld nicht bewegen muss, wird die Eingabe insgesamt beschleunigt und zugleich der Nutzungskomfort für den Bediener erhöht.

Welche Eingabewerte mit dem erfindungsgemäßen Verfahren in das Lichtstellpult eingegeben werden, ist grundsätzlich beliebig. Gemäß einer ersten Ausführungsvariante ist es vorgesehen, dass durch Auswertung des ersten Drehsignalgebers ein X-Koordinatenwert einer Tabelle und durch Auswertung des zweiten Drehsignalgebers ein Y-Koordinatenwert der gleichen Tabelle eingegeben wird. Auf diese Weise kann der Benutzer sich sehr schnell in Wertetabellen bewegen und eine von ihm gesuchte Wertezelle in der Tabelle aufsuchen.

Alternativ dazu kann das erfindungsgemäße Verfahren auch genutzt werden, um Bewegungsstellbefehle einfach und bequem in das Lichtstellpult einzugeben. Durch Drehen der ersten Welle wird der erste Bewegungsstellbefehl, beispielsweise ein Pan-Wert einer entsprechend verstellbaren Leuchte, und durch Drehen der zweiten Welle ein zweiter Bewegungsstellbefehl, beispielsweise der Tilt-Wert der Leuchte, eingegeben.

Gemäß einer weiteren Variante wird der Doppelwellenencoder genutzt, um nacheinander zunächst einen Grobwert einer Werteskala und dann einen Feinwert in der gleichen Werteskala einzugeben. Durch Drehen der ersten Welle wird zunächst der Grobwert der Skala angesteuert und dann durch Drehen der zweiten Welle vom Grobwert ausgehend ein Feinwert eingegeben.

An gattungsgemäßen Lichtstellpulten sind vielfach große Befehlsmenüs vorhanden, durch die der Benutzer sich während der Programmierung hindurchbewegen muss. Um das Ansteuern bestimmter Befehle im Befehlsmenü zu erleichtern, kann diese entsprechende Stellbewegung durch das Befehlsmenü mittels der Nutzung des erfindungsgemäßen Doppelwellenencoders erleichtert werden. Durch Drehen der ersten Welle scrollt der Benutzer dann vertikal durch das Befehlsmenü und kann durch Drehen der zweiten Welle eine horizontale Bewegung durch das Befehlsmenü bewirken.

Soweit der Doppelwellenencoder des erfindungsgemäßen Lichtstellpults mit einer axial verstellbaren Welle und einem entsprechenden Schaltsensor ausgestattet ist, können die durch Verdrehen der beiden Wellen eingestellten Eingabewerte in einfacher Weise zur Weiterverarbeitung freigegeben werden. Dies erfolgt gemäß einer besonderen Verfahrensvariante dadurch, dass nach Einstellung der beiden Eingabewerte durch Verdrehen der beiden Wellen die axial verstellbare Welle gedrückt und das dadurch erzeugte Datensignal des Schaltsensors ausgewertet wird. Sobald das entsprechende Datensignal des Schaltsensors eingeht, werden die an den beiden Wellen eingestellten Eingabewerte ausgelesen und für die Weiterverarbeitung im Lichtstellpult freigegeben.

Neben den bereits erwähnten Anwendungsmöglichkeiten des erfindungsgemäßen Verfahrens können durch Nutzung des Doppelwellenencoders auch andere diverse Eingaben erleichtert bzw. beschleunigt werden. So können bei Eingaben von Farben zwei Farben gemischt bzw. die Farbtemperatur geändert werden. Auch können zwei Goboräder gleichzeitig durch Verdrehen der Wellen eingestellt werden. Dimmen, Zoomen und Scharfstellen bzw. die Einstellung von Rotationsbewegungen in Geschwindigkeit und Startwinkel sind denkbar.

Eine Ausführungsform der Erfindung ist in den Zeichnungen schematisch dargestellt und wird nachfolgend beispielhaft erläutert.

Es zeigen:
- **Fig. 1**: ein Lichtstellpult mit zwei Doppelwellenencodern in perspektivischer Ansicht von oben;
- **Fig. 2**: die Elektronikplatine des Lichtstellpults gemäß Fig. 1, auf der die Doppelwellenencoder montiert sind, in perspektivischer Ansicht von oben;
- **Fig. 3**: die Betätigungselemente an einem Doppelwellenencoder des Lichtstellpults gemäß Fig. 1 im Querschnitt;
- **Fig. 4**: den Doppelwellenencoder des Lichtstellpults gemäß Fig. 1 in perspektivischer seitlicher Ansicht;
- **Fig. 5**: den Doppelwellenencoder gemäß Fig. 3 unter Fortlassung des Gehäuses in perspektivischer seitlicher Ansicht;
- **Fig. 6**: die beiden drehbar gelagerten Wellen des Doppelwellenencoders gemäß Fig. 3 in einer perspektivischen Explosionszeichnung;
- **Fig. 7**: den Doppelwellenencoder gemäß Fig. 3 in einer ersten seitlichen Ansicht;
- **Fig. 8**: den Doppelwellenencoder gemäß Fig. 6 im Querschnitt entlang der Schnittlinie I-I unter Fortlassung des umgebenden Gehäuses;
- **Fig. 9**: den Doppelwellenencoder gemäß Fig. 3 in einer zweiten seitlichen Ansicht;
- **Fig. 10**: den Doppelwellenencoder gemäß Fig. 8 im Querschnitt entlang der Schnittlinie 11-11.

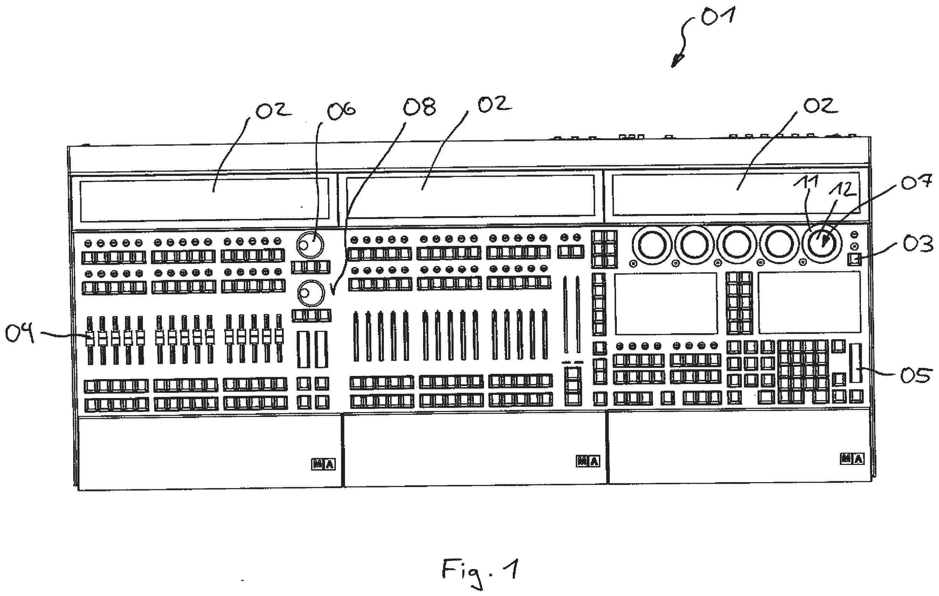

**Fig. 1** zeigt in perspektivischer Ansicht ein erfindungsgemäßes Lichtstellpult 01 zur Programmierung und Steuerung einer Bühnenbeleuchtungsanlage. Das Lichtstellpult 01 ist mit drei Monitoren 02 zur Anzeige von diversen Menüs für den Benutzer ausgestattet. Zur Eingabe von Stellbefehlen ist am Lichtstellpult 01 eine Vielzahl von Druckknöpfen 03, Schiebereglern 04 und Stellrädern 05 vorgesehen. Außerdem sind zur Eingabe von Bedienbefehlen fünf einfache Drehwellenencoder 06 und zwei Doppelwellenencoder 07 in das Bedienfeld 08 des Lichtstellpults 01 eingebaut.

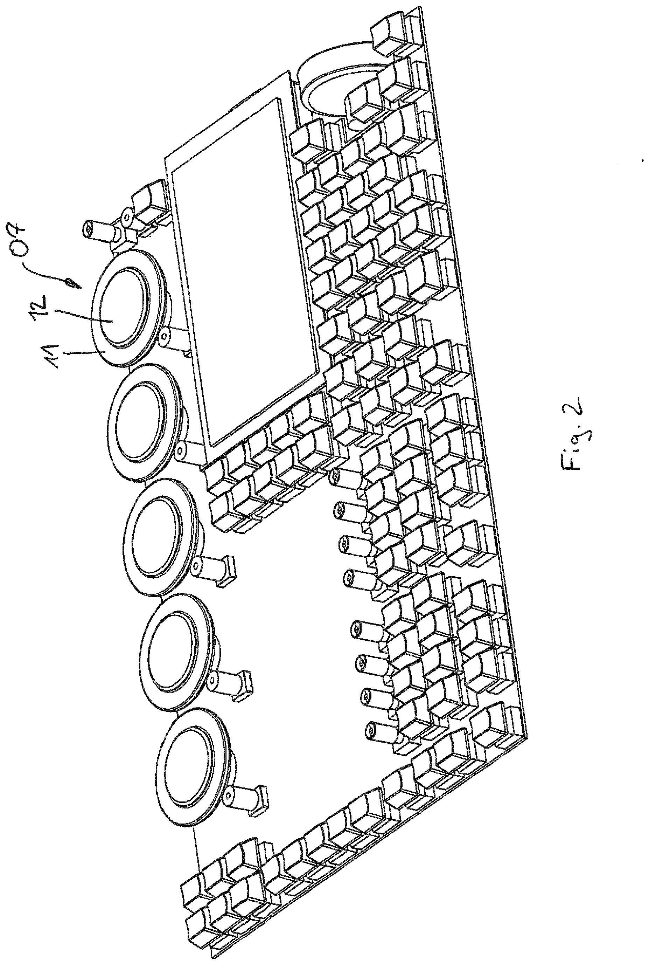

**Fig. 2** zeigt die Elektronikplatine des Lichtstellpults gemäß Fig. 1, auf der die Doppelwellenencoder montiert sind, in perspektivischer Ansicht von oben.

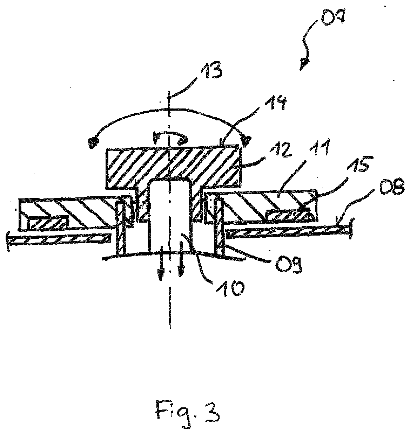

**Fig. 3** zeigt den oberen Teil eines Doppelwellenencoders 07 im Querschnitt. Der in das Bedienfeld 08 des Lichtstellpults 01 eingebaute Doppelwellenencoder weist zwei drehbar gelagerte Wellen, nämlich eine Hohlwelle 09 und eine darin koaxial drehbar gelagerte Zentralwelle 10, auf. In Fig. 3 sind nur die oberen Enden der Hohlwelle 09 und der Zentralwelle 10 dargestellt. Die Funktion der Hohlwelle 09 und der Zentralwelle 10 wird weiter unten anhand der anderen Zeichnungen erläutert. An den oberen Enden der Hohlwelle 09 und der Zentralwelle 10 sind zwei Betätigungselemente, nämlich eine Drehscheibe 11, mit der die Hohlwelle 09 verdreht werden kann, und ein Drehknopf 12, mit dem die Zentralwelle 10 verdreht werden kann, befestigt.

Durch Handbetätigung der Drehscheibe 11 bzw. des Drehknopfs 12 können die Hohlwelle 09 und die Zentralwelle 10 rotatorisch um ihre Längsachse 13 unabhängig voneinander verdreht werden, um dadurch Stellbefehle in das Lichtstellpult 01 einzugeben. Die Hohlwelle 09 ist dabei zusätzlich axial in Richtung der Längsachse 13 verstellbar gelagert, so dass der Benutzer durch Druck auf die Oberseite 14 des Drehknopfs 12 einen durch Verdrehen der Hohlwelle 09 eingestellten Wert auswählen und bestätigen kann. Die Drehscheibe 11 ist an ihrer Unterseite mit einem ringförmigen Beschwerungsgewicht 15 ausgestattet, das beispielsweise durch Einspritzen eines Metallrings in die aus Kunststoff bestehende Drehscheibe 11 hergestellt werden kann. Durch das zusätzliche Gewicht des Beschwerungsgewichts 15 kann ein höherer Drehimpuls auf die Drehscheibe 11 übertragen werden. Dadurch hat der Benutzer die Möglichkeit, die Drehscheibe 11 mit den Fingern in Schwung zu versetzen und dadurch eine starke Drehbewegung der Drehscheibe 11 zu realisieren.

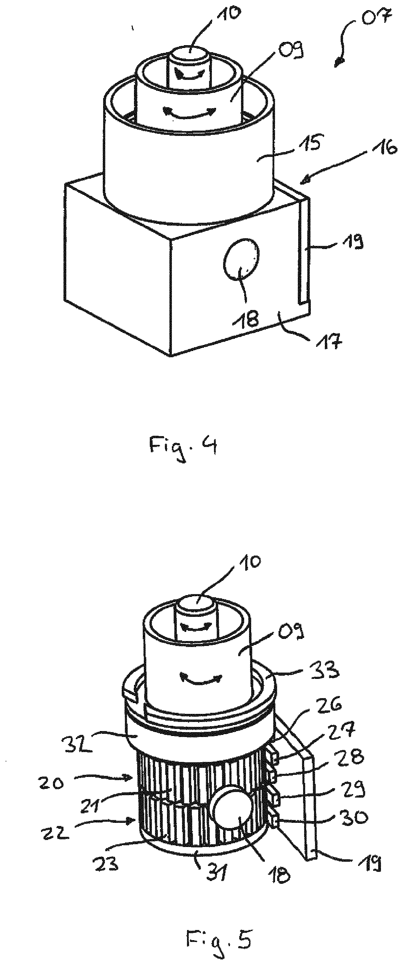

**Fig. 4** zeigt den Doppelwellenencoder 07 mit den drehbar gelagerten Wellen 09 und 10 in perspektivischer seitlicher Ansicht. Die Hohlwelle 09 ist im zylindrischen Oberteil 15 des Gehäuses 16 drehbar gelagert. Die Zentralwelle 10 ist in der Hohlwelle 09 drehbar gelagert. An das Oberteil 15 des Gehäuses 16 schließt sich ein rechteckiges Unterteil 17 an, das zur Befestigung der Magnete des magnetisch wirkenden Rastwerks, nämlich zweier Permanentmagnete 18, und einer elektronischen Trägerplatine 19, auf deren Innenseite die Sensoren des Doppelwellenencoders 07 angeordnet sind, dient.

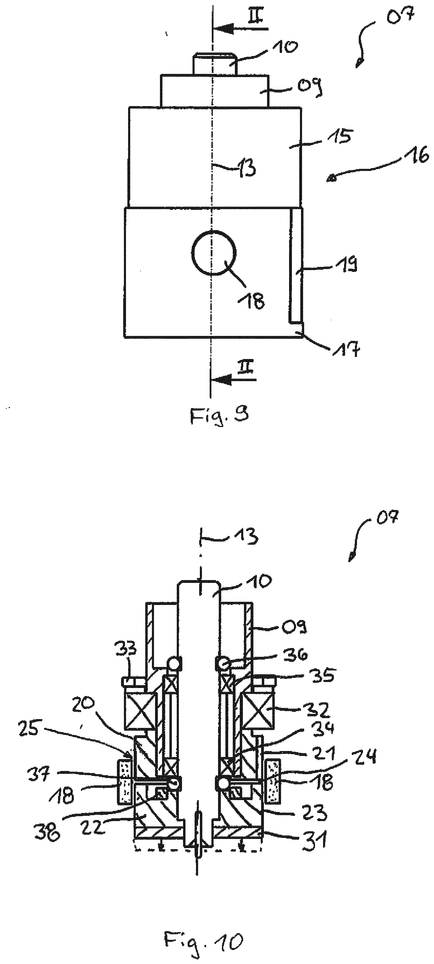

**Fig. 5** zeigt den Doppelwellenencoder 07 ohne das Gehäuse 16. An der Hohlwelle 09 ist ein erster Rastring 20 befestigt, an dessen Außenumfang sich jeweils Radialfortsätze 21 nach außen erstrecken. An der Zentralwelle 10 ist ein im Wesentlichen baugleicher Rastring 22 mit Radialfortsätzen 23 befestigt. Die beiden Rastringe 20 und 22 befinden sich in der Einbaulage direkt übereinander und wirken zur Realisation eines magnetischen Rastwerks mit dem Permanentmagneten 18 und einem spiegelsymmetrisch an der gegenüberliegenden Seite des Gehäuses 16 angebrachten zweiten Permanentmagneten 18 zusammen. Die spiegelsymmetrische Anordnung der beiden Permanentmagnete 18 ist aus der Schnittdarstellung in Fig. 9 ersichtlich. Beide Permanentmagnete 18 sind im Gehäuse 16 so angeordnet, dass sie dem Spalt 24 zwischen den beiden Rastringen 20 und 22 mittig gegenüberliegen. Auf diese Weise können die beiden Permanentmagnete 18 sowohl mit den Radialfortsätzen 21 als auch mit den Radialfortsätzen 23 der beiden Rastringe 20 und 22 zur Realisation des magnetischen Rastwerks zusammenwirken. Aufgrund der Änderung des Außenumfangs der Rastringe 20 und 22 entsprechend der Höhe der Radialfortsätze 21 und 22 ändert sich die Breite des Luftspalts 25 zwischen den Permanentmagneten 18 einerseits und den Rastringen 20 bzw. 22 andererseits. Bei einem kleinen Luftspalt 25 bewirken die Permanentmagnete 18 einen hohen magnetischen Fluss durch das magnetische Material der Rastringe 20 und 22 und eine entsprechend hohe Rastkraft. Wird dann durch Verdrehen der Welle 09 bzw. 10 der Luftspalt 25 vergrößert, folgt daraus eine Verringerung der magnetischen Rastkraft, so dass im Ergebnis die Rastkraft der Permanentmagnete 18, die auf die Rastringe 20 und 22 ausgeübt wird, zwischen einem Kraftmaximum und einem Kraftminimum abwechselt und dadurch die gewünschte Rastwirkung an den Wellen 09 und 10 des Doppelwellenencoders 07 realisiert.

Auf der Trägerplatine 19 sind innenseitig vier Drehsignalgeber 26, 27, 28 und 29 befestigt und elektronisch kontaktiert. Die Drehsignalgeber 26 bis 29 sind in der Art von Hallsensoren ausgebildet und arbeiten zur Detektion des Umschaltens zwischen zwei Rastlagen mit den Radialfortsätzen 21 bzw. 23 der Rastringe 20 und 22 zusammen. Die Drehsignalgeber 26 und 27 sind dabei dem Rastring 20 und die Drehsignalgeber 28 und 29 dem Rastring 22 zugeordnet. Mittels der Ausgangssignale der Drehsignalgeber 26 bis 29 und durch Analyse der Phasenverschiebung des Drehsignalgebers 27 relativ zum Drehsignalgeber 26 bzw. des Drehsignalgebers 29 relativ zum Drehsignalgeber 28 können die Verstellung der Rastringe 20 und 22 und die Drehrichtung detektiert werden.

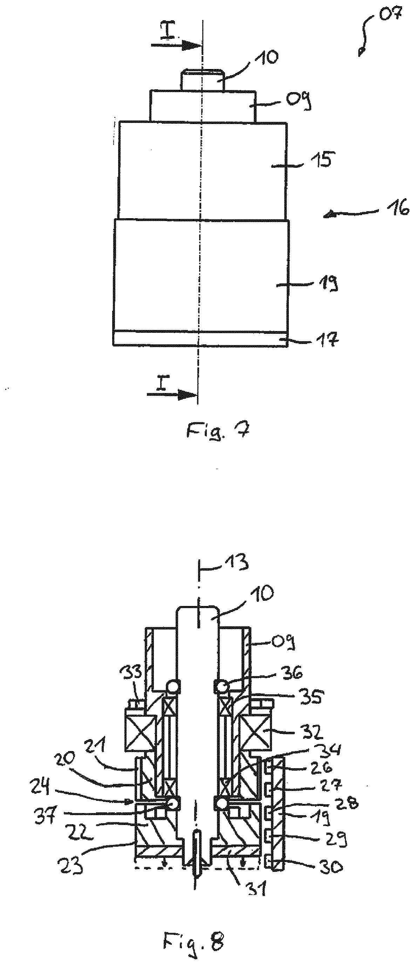

Außerdem ist auf der Trägerplatine 19 ein zusätzlicher Schaltsensor 30, der ebenfalls in der Art eines berührungslos arbeitenden Hallsensors ausgebildet ist, befestigt und elektronisch kontaktiert. Der Schaltsensor 30 arbeitet dabei mit einer Signalscheibe 31 zusammen, die unterhalb des Rastrings 22 an der Zentralwelle 10 befestigt ist. Befindet sich die axial verstellbare Zentralwelle 10 in ihrer axialen Ruhestellung, wie in Fig. 8 dargestellt, so befindet sich die Signalscheibe 31 oberhalb des Schaltsensors 30. Wird die Zentralwelle 10 dann zur Bestätigung eines zuvor eingestellten Werts vom Benutzer axial nach unten gedrückt, so gelangt die zentrale Welle 10 in ihre Schaltstellung, in der die Signalscheibe 31 dem Schaltsensor 30 direkt gegenüberliegt (strichliniert angedeutet in Fig. 8).

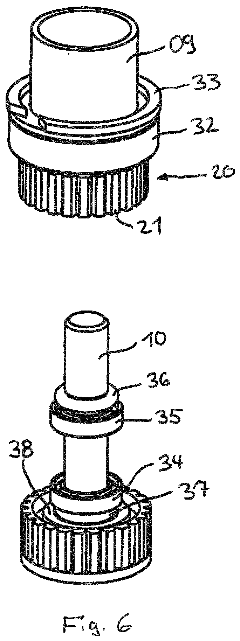

**Fig. 6** zeigt die beiden Wellen 09 und 10 mit den jeweils daran befestigten Rastringen 20 und 22 ohne das Gehäuse 16 in einer Explosionsdarstellung. Die Hohlwelle 09 wird mittels eines Wälzlagers 32 im zylindrischen Oberteil 15 des Gehäuses 16 drehbar gehalten. Ein Sprengring 33 dient der Befestigung des Wälzlagers 32 mit der Hohlwelle 09 im Gehäuse 16.

Die Zentralwelle 10 ist mit zwei Wälzlagern 34 und 35 im Inneren der Hohlwelle 09 drehbar und axial verstellbar gelagert. Zur Dämpfung der axialen Stellbewegung der Zentralwelle 10 dienen zwei Gummiringe 36 und 37. Außerdem ist an der Oberseite des Rastrings 22 ein ringförmiger Rückstellmagnet 38 befestigt, dessen Magnetkraft die Zentralwelle 10 in ihre in Fig. 7 dargestellte Ruhestellung zurückzieht. Bei Druck des Benutzers auf das obere Ende der Welle 10 wird die magnetische Haltekraft des Rückstellmagneten 38 bei einer bestimmten Schwelle überschritten und die Welle 10 mit dem Rastring 22 und der Signalscheibe 31 in ihre strichlinierte Schaltstellung axial verstellt.

**Fig. 7** zeigt den Doppelwellenencoder gemäß Fig. 3 in einer ersten seitlichen Ansicht.

**Fig. 8** zeigt den Doppelwellenencoder gemäß Fig. 6 im Querschnitt entlang der Schnittlinie I-I unter Fortlassung des umgebenden Gehäuses.

**Fig. 9** zeigt den Doppelwellenencoder gemäß Fig. 3 in einer zweiten seitlichen Ansicht.

**Fig. 10** zeigt den Doppelwellenencoder gemäß Fig. 8 im Querschnitt entlang der Schnittlinie 11-11.

## Patentansprüche

1. Lichtstellpult (01) zur Steuerung einer Beleuchtungsanlage, wobei im Lichtstellpult (01) digitale Stellbefehle erzeugt werden, die über Datenverbindungen an die Beleuchtungseinrichtungen der Beleuchtungsanlage übertragen werden können, und wobei das Lichtstellpult (01) zumindest einen Digitalprozessor und zumindest einen Digitalspeicher zur Erzeugung, Verwaltung und Speicherung der Stellbefehle umfasst, und wobei das Lichtstellpult (01) zumindest eine Anzeigeeinrichtung umfasst, und wobei an der Anzeigeeinrichtung Grafikelemente für den Benutzer grafisch dargestellt werden können, **dadurch gekennzeichnet**
**dass** im Bedienfeld (08) des Lichtstellpults (01) zumindest ein Doppelwellenencoder (07) vorgesehen ist, an dem Eingabewerte vom Benutzer eingegeben werden können, wobei der Doppelwellenencoder (07) eine erste drehbar in einem Gehäuse (16) gelagerte Welle (09) aufweist, und wobei an der ersten Welle (09) ein erstes Rastwerk zur Verrastung unterschiedlicher Drehlagen der ersten Welle (09) und zumindest ein erster Drehsignalgeber (26, 27) zur Erzeugung eines ein Umschalten zwischen zwei Rastlagen anzeigenden Datensignals vorgesehen sind, und wobei am Doppelwellenencoder (07) eine zweite, koaxial drehbar in dem Gehäuse (16) gelagerte Welle (10) vorgesehen ist, und wobei an der zweiten Welle (10) ein zweites Rastwerk zur Verrastung unterschiedlicher Drehlagen der zweiten Welle (10) und zumindest ein zweiter Drehsignalgeber (28, 29) zur Erzeugung eines ein Umschalten zwischen zwei Rastlagen anzeigenden Datensignals vorgesehen sind, und wobei beide Wellen (09, 10) Betätigungselemente (11, 12) aufweisen, an denen Stellbewegungen von Hand auf die Wellen (09, 10) übertragen werden können.

2. Lichtstellpult nach Anspruch 1,
**dadurch gekennzeichnet,**
**dass** an der ersten Welle (09) und an der zweiten Welle (10) jeweils ein Rastring (20, 22) aus einem magnetisierbaren Material drehfest angeordnet ist, wobei am Außenumfang der beiden Rastringe (20, 22) jeweils mehrere Radialfortsätze (21, 23) vorgesehen sind, und wobei im Gehäuse (16) den Radialfortsätzen (21, 23) gegenüberliegend zumindest ein Magnet (18) angeordnet ist, und wobei die Breite des Luftspalts (25) zwischen dem Magneten (18) einerseits und den Rastringen (20, 22) anderseits drehlagenabhängig zwischen einer Maximalbreite und einer Minimalbreite variiert, und wobei die von der Breite des Luftspalts (25) abhängige magnetische Haltekraft eine Verrastung unterschiedlicher Drehlagen der beiden Wellen (09, 10) gegenüber dem Gehäuse (16) bewirkt.

3. Lichtstellpult nach Anspruch 1,
**dadurch gekennzeichnet,**
**dass** eine Welle in der Art einer Hohlwelle (09) ausgebildet ist, die mit zumindest einem Wälzlager (32) im Gehäuse (16) drehbar gelagert ist, wobei die zweite Welle (10) mit zumindest einem weiteren Wälzlager (34, 35) in der Hohlwelle (09) koaxial drehbar gelagert ist.

4. Lichtstellpult nach Anspruch 1,
**dadurch gekennzeichnet,**
**dass** die beiden Rastringe (20, 22) den gleichen Außenumfang aufweisen und in Richtung der Längsachse (13) der Wellen (09, 10) hintereinander im Gehäuse (16) angeordnet sind, wobei der Magnet (18) dem Spalt (24) zwischen den Rastringen (20, 22) mittig gegenüberliegend im Gehäuse (16) angeordnet ist, und wobei die magnetische Haltekraft des Magneten (18) auf beide Rastringe (20, 22) gleichzeitig einwirkt.

5. Lichtstellpult nach Anspruch 1,
**dadurch gekennzeichnet,**
**dass** die Drehsignalgeber (26, 27, 28, 29) als berührungslos arbeitende Drehsignalgeber, insbesondere als Reflexlichtschranken oder Hallsensoren (26, 27, 28, 29), ausgebildet sind, wobei die Stellbewegungen der Radialfortsätze (21, 23) an den Rastringen (20, 22) zur Erzeugung des Umschaltsignals zwischen zwei Rastlagen mit dem berührungslos arbeitenden Drehsignalgeber (26, 27, 28, 29) detektierbar sind.

6. Lichtstellpult nach Anspruch 1,
**dadurch gekennzeichnet,**
**dass** jedem Rastring (20, 22) jeweils zwei Drehsignalgeber (26, 27 / 28, 29) zugeordnet sind, wobei aus der Phasenverschiebung des Umschaltsignals der beiden Drehsignalgeber (26, 27 / 28, 29) die Drehrichtung des zugeordneten Rastrings (20, 22) detektierbar ist.

7. Lichtstellpult nach Anspruch 1,
**dadurch gekennzeichnet,**
**dass** zumindest eine Welle (10) zwischen einer Ruhestellung und einer Schaltstellung in Richtung ihrer Längsachse (13) axial verstellbar im Gehäuse (16) gelagert ist, wobei im Gehäuse (16) ein Schaltsensor (30) vorgesehen ist, mit dem die Ruhestellung und/oder Schaltstellung der axial verstellbaren Welle (10) detektierbar ist.

8. Lichtstellpult nach Anspruch 7,
**dadurch gekennzeichnet,**
**dass** der Schaltsensor (30) als berührungslos arbeitender Schaltsensor, insbesondere als Reflexlichtschranke oder Hallsensor, ausgebildet ist, wobei die Stellbewegungen der axial verstellbaren Welle (10) mittelbar oder unmittelbar detektierbar sind.

9. Lichtstellpult nach Anspruch 7,
**dadurch gekennzeichnet,**
**dass** an der axial verstellbaren Welle (10) eine Signalscheibe (31) befestigt ist, wobei die Stellbewegungen der Signalscheibe (31) mit dem Schaltsensor (30) berührungslos detektierbar sind.

10. Lichtstellpult nach Anspruch 7,
**dadurch gekennzeichnet,**
**dass** die axial verstellbare Welle (10) mittels eines Rückstellmagneten (38) in ihrer Ruhestellung gehalten wird.

11. Lichtstellpult nach Anspruch 7,
**dadurch gekennzeichnet,**
**dass** die Stellbewegungen der axial verstellbaren Welle (10) zwischen der Ruhestellung und der Schaltstellung mit zumindest einem Dämpfungselement, insbesondere mit einem Gummiring (36, 37), gedämpft werden.

12. Lichtstellpult nach Anspruch 1,
**dadurch gekennzeichnet,**
**dass** die Betätigungselemente zur handbetätigten Verstellung der Wellen (09, 10) in der Art von Drehknöpfen (12) oder Drehscheiben (11) ausgebildet sind, die im Bedienfeld (08) des Lichtstellpults (01) in Richtung der Längsachse (13) der Wellen (09, 10) übereinander angeordnet sind und koaxial gegeneinander verdreht werden können.

13. Lichtstellpult nach Anspruch 12,
**dadurch gekennzeichnet,**
**dass** an zumindest einem Betätigungselement (11) ein Beschwerungsgewicht (15) befestigt ist.

14. Lichtstellpult nach Anspruch 1,
**dadurch gekennzeichnet,**
**dass** der Magnet (18) des Rastwerks in der Art eines Permanentmagneten (18) oder in der Art eines Elektromagneten ausgebildet ist.
